# EUROPEAN PATENT SPECIFICATION

(11) **EP 0 847 542 B1**
(45) Date of publication and mention of the grant of the patent: **01.03.2006**
(21) Application number: 96928777.0
(22) Date of filing: 21.08.1996
(51) Int. Cl.: G02B 6/42, H05K 9/00, G02B 6/36

(54) **AN OPTO MODULE**
EIN OPTISCHES MODUL
MODULE OPTIQUE

(30) Priority: 21.08.1995 SE 9502895
(43) Date of publication of application: 17.06.1998
(73) Proprietor: TELEFONAKTIEBOLAGET LM ERICSSON (publ), 164 83 Stockholm (SE)
(72) Inventor: HENNINGSON, Uno, S-149 30 Nynäshamn (SE); LYNN, Michael, S-191 62 Sollentuna (SE)
(74) Representative: Holmberg, Martin Tor
(86) International application number: PCT/SE1996/001035
(87) International publication number: WO 1997/007421

(56) References cited:
- EP-A- 0 437 161
- EP-A- 0 437 931
- EP-A- 0 517 346
- EP-A- 0 586 930
- EP-A- 0 652 696
- WO-A-90/14607
- US-A- 4 327 964
- US-A- 4 355 862
- US-A- 4 979 787

## Description

### Technical area.

The present invention relates to an electro-optic circuit with an arrangement that comprises optic sender and receiver components for transforming an electric output signal to an outgoing optic signal and for transforming a received optic signal to an electric input signal, respectively, connection means for an opto conductor on which the outgoing and received optic signals are transmitted, a sender for the electric output signal, and a receiver for the electric input signal.

### State of the art.

Electro-optic circuits of this kind are used e.g. located on a printed circuit card in a telecommunication switch. Each circuit card carries a plurality of such electro-optic circuits and in the switch one or more cabinets can contain a plurality of shielded card magazines, each of which contains a plurality of such circuit cards. For increasing the insensitivity towards EMC, i.e. electromagnetical disturbance radiation, senders and receivers are conventionally located far in on the card as seen from its edge located at an outer cabinet wall, below denominated card front. On the card front there are seated a number of connection devices for connecting an outer opto conductor to two opto conductors leading to the sender and receiver, respectively, of a corresponding sender/receiver pair. For minimizing the risk for interference between sender and receiver of each sender/receiver pair the sender and the receiver are furthermore located remote from each other on the card.

This distribution of the components of the electro-optic circuit counteracts a striving for a more compact architecture of switches of the just described type, while saving or further improving the insensitiveness for EMC, as well as ESD, i.e. electrostatical discharges.

EP-A-652696 discloses an electro-optic circuit arrangement with a transmitter 72 and a receiver 76 arranged side by side on a common card contained in a cavity 36 of a shielded housing 20. The cavity 36 is divided into two portions by a lid shield 52.

EP-A-437931 discloses a packaging arrangement for optical devices, where securing means are used in the form of metallic spring clip 27 that provides additional shielding for the optical devices.

WO-A-9014607 discloses a housing for two opto-electronic devices placed on separate circuit boards 38, 38. The housing includes a base 62 and a cover 64 in which a shielding partition 96, 138S is formed between the circuit boards 38, 38.

EP-A-437161 discloses an optical fiber link card having transmitter components located on one side and receiver components located on the opposite side, the two sides being separated by shielding layers in the card.

However, none of these previous solutions provide a satisfactory combination of compactness and reliable shielding against EMC and ESD.

### Summary of the invention.

One object of the invention is to provide an electro-optic circuit of the kind defined by way of introduction that has a very compact design and great insensitiveness to EMC and ESD and thereby can be mounted at the card front as a unit.

This object has been achieved by an electro-optic circuit with an arrangement according to claim. In particular, the electro-optic circuit forms a module with an electromagnetically shielded housing that contains said optical sender and receiver components and said connection means, and a two-sided printed circuit arrangement that carries the sender and the receiver located shielded from each other on one side each by means of an electrically conducting shielding that is in connection with the housing for forming, one Faraday's cage for the sender and another Faraday's cage for the receiver.

Embodiments of the invention have then received the features stated in respective subclaims.

### Description of drawings.

The invention will now be described more closely with reference to the attached drawings, on which
Fig. 1 is a perspective view of a housing for an electro-optic circuit mounted on a mother printed circuit card,
Fig. 2 shows an exploded view of the housing shown in Fig. 1 with the parts thereof as well as components enclosed thereby being shown in perspective,
Fig. 3 shows a perspective view of a contact spring module according to the invention used in the housing and intended to be used between different elements, forming parts of the housing according to Fig. 1, a printed circuit card introduced in the housing and the mother card,
Figs. 4 and 5 show sections in the direction of arrows IV-IV in Fig. 3 through the contact spring module for illustrating cooperation thereof with the elements shown in Fig. 3,
Fig. 6 shows a perspective view of a housing for a contact means,
Fig. 7 shows an exploded view of the housing shown in Fig. 6 with the parts thereof as well as components enclosed therein in perspective,
Fig. 8 shows a perspective view of a component enclosed in the housing according to Figs. 6 and 7 and turned 90° anticlockwise in the same plane as the corresponding perspective view in Fig. 7,
Fig. 9 shows a perspective view of the same component as in Fig. 8, although turned 180° about a length axis with respect to the corresponding perspective view in Fig. 7,
Fig. 10 shows a longitudinal section of another component enclosed in the housing according to Fig. 7.

### Preferred embodiment.

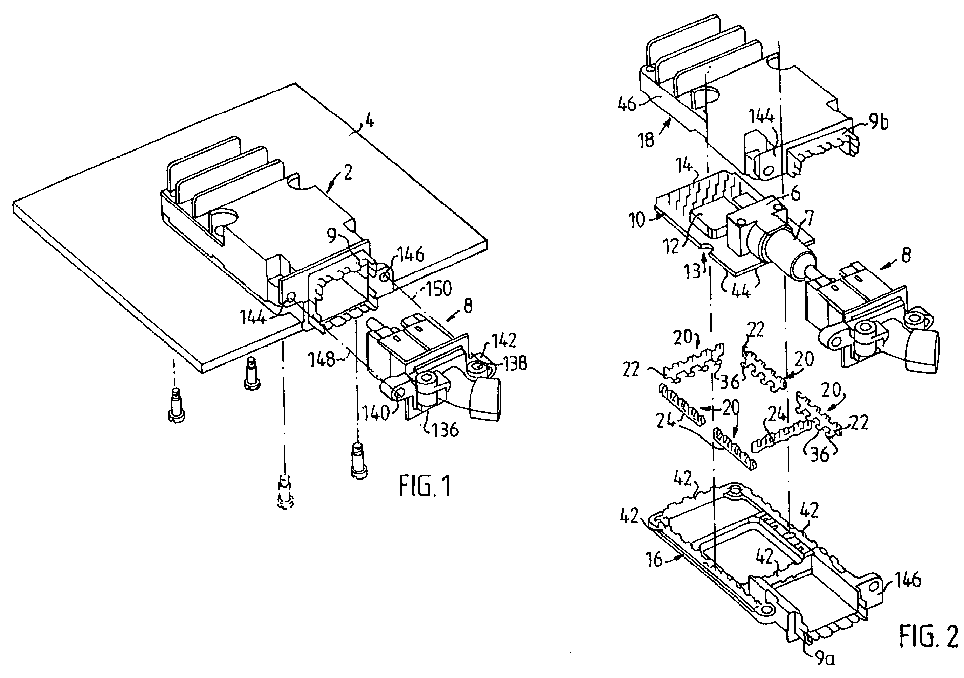

Fig. 1 shows the housing for an electro-optic circuit according to the invention, generally designated 2, and mounted on a mother card 4. The housing 2, the design of which appears more closely from Fig. 2, contains connection means in the form of a housing 6 with a receiving tube 7 for receiving one end of an opto conductor. The opto conductor is kept fixedly by a connection device generally designated 8 and received in an opening in a guiding-in part generally designated 9. The connection device 8 will be described more closely further on.

The housing 6 contains an electro-optic component not shown and comprising optic sender and receiver component parts for transforming an electric output signal to an outgoing optic signal, and for transforming a received opto signal to an electric input signal, respectively. The optic sender and receiver component parts can be combined into a unit, e.g. Duplex-2 from ABB HAFO, that admits use of one single opto fibre for transfer in both directions to and from the electro-optic component.

The housing 2 furthermore encloses a printed circuit card arrangement 10 on which the housing 6 is attached. The printed circuit card arrangement 10 is in the form of a sender/receiver printed circuit card 10 and is henceforth, for the sake of simplicity, denominated "printed circuit card" or, alternatively, "sender/receiver printed circuit card", despite the fact that it, as described below, can consist of a sandwich of two printed circuit cards. The printed circuit card 10 on one side carries a sender circuit for the electric output signal and on the other side a receiver circuit for the electric input signal. The circuits are indicated for the upper side of the card at 12 and for the lower side of the card with an arrow 13, but are not shown more closely for the rest. The card 10 furthermore carries connections, not shown, between inputs and outputs of the sender and receiver circuits, respectively, on the one hand, and connection pins 14 on the other hand, that extend through the housing to the outside thereof for connection to outer circuits on the mother card 4.

The housing 2 has a lower part 16 and an upper part 18, both metallic, comprising each one half 9a and 9b, respectively, of the guiding in part 9. Between the lower part 16 and the upper part 18, the sender/receiver printed circuit card 10 is located, the housing containing contact means, described more closely below, between the parts of the housing and between the housing and grounding parts of the sender/receiver printed circuit card 10 and the outer card 4, respectively. As will appear more clearly below said grounding parts of the mother card form part of a metallic layer applied in the card in parallel with and between the two sides of the printed circuit card. The printed circuit card 10 can then consist of one single printed circuit card in which the metallic layer is formed by an integrated conducting layer between the sides of the card. The printed circuit card 10 can, however, also be sandwich-like composed of two printed circuit cards connected together side to side via the metallic layer. The metallic layer can also include a magnetic material, e.g. in the form of a nickel plate for shielding against inductive cross-induction. By the design of the housing 2 just described it forms three Faraday's cages. Two of the cages each enclose one of the sender and receiver circuits 12 and 13, respectively, one consisting of the lower part 16 of the housing and the metallic layer of the printed circuit card 10, and the other one consisting of the upper part 18 of the housing and the metallic layer of the printed circuit card. The third cage is the housing 2 in its entirety.

The above mentioned contact means consist of a number of longitudinal spring means 20 along the sides of the housing parts 16 and 18. Each spring means 20 is made in one piece and comprises a number of contact points for the sender/receiver printed circuit card 10, a number of contact points for the housing lower part 16, a number of contact points for the housing upper part 18, and a number of contact points for the mother card 4.

Each spring means has a first essentially rib-shaped web part 22 extending along the longitudinal direction of the spring means. A second web part 24 extends along and at a distance from the first web part 22 and is connected thereto by means of arcuate connection pieces 26 extending from a first side edge 28 of the first web part to a nearby first side edge 30 of the second web part. First contact tongues 32 are bent away from the first side edge 30 of the second web part in a direction towards the first web part 22 and end between the planes of the two web parts. Second contact tongues 34 are arcuately bent away from the first side edge 28 of the first web part 22 in a direction towards the second web part 24 and end outside the plane of the second web part. Each one of the first and one of the second contact tongues 32 and 34, respectively, are arranged pairwise in the spaces between the arcuate connection pieces 26. Third contact tongues 36 are bent away from the second side edge of the first web part 22 in a direction outwardly from the two web parts. Each one of the third contact tongues 36 has an inner leg 38 bent away from the first web part 22 and an outer leg 40 connected thereto and bent away from the inner leg for forming an acute angle between the two legs.

The web part 22 extends between the inside of a side wall 42 standing up from the bottom wall of the lower part 16 and an opposite side edge 44 of the sender/receiver printed circuit card 10. The web part 24 extends between the outside of the side wall 42 of the lower part and the inside of a side wall 46 extending downwardly from the upper wall of the upper part 18. The contact tongues 32 are located in contact with the outside of the side wall 42 of the lower part 16. The contact tongues 34 are located in contact with the inside of the side wall 46 of the housing upper part 18.

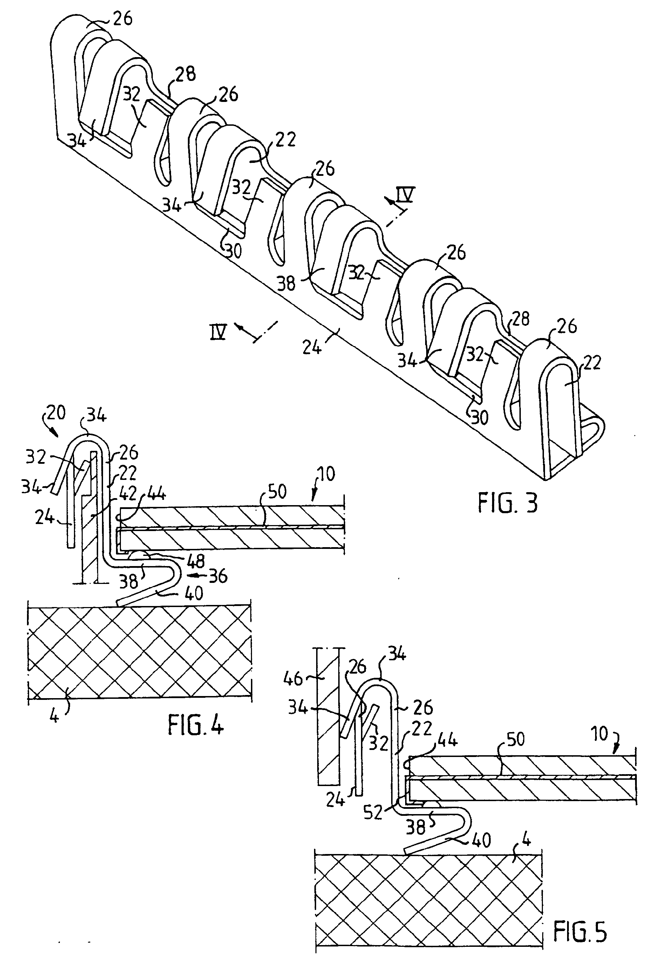

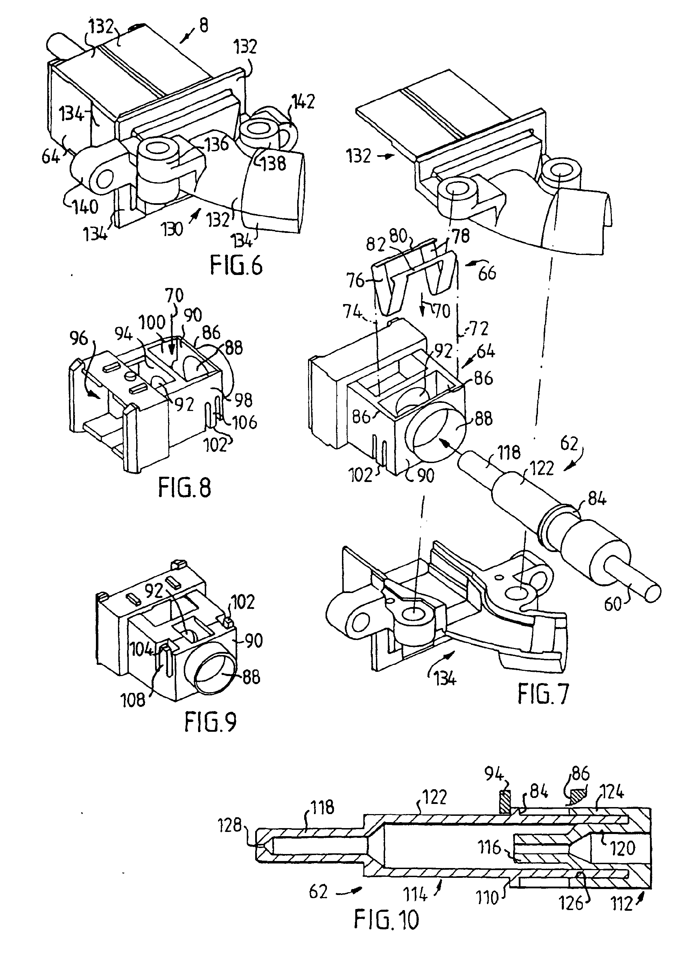

The contact tongues 36 extend between and abut grounding parts, not shown, on the lower side of the sender/receiver printed circuit card 10 and the upper side of the mother card 4. The inner leg 38 of each contact tongue 36 has an upper side formed with a contact boss 48, making contact with the grounding part of the sender/receiver printed circuit card 10. The outer leg 40 makes contact with the grounding part of the mother card 4. In Figs. 4 and 5 the earlier mentioned inner metallic layer of the card 10 is indicated at 50, as well as an outer continuation 52 thereof, that extends outwardly on the edge 28 of the card 10 to its lower side for forming said grounding part of the card 10 there.

In Figs. 6-10 an embodiment of the connection device 8 is illustrated more closely with respect to its design and function, which is intended for connecting one end of a sheathed opto fibre 60 to the electro-opto component enclosed in the housing 6.

The connection device 8 includes, while referring particularly to Fig. 7, a retaining sleeve generally designated 62 for a portion of the fibre connecting to said end of the sheathed opto fibre 60, a supporting structure, generally designated 64, for the retaining sleeve 62 intended to be fixed with respect to the electro-opto component in a way to be disclosed more closely below, and a spring 66 acting between the retaining sleeve 62 and the supporting structure 64. More particularly, the spring 66 shall, at connection to the electro-opto component in the housing 6, compensate for tolerances in the length direction of the retaining sleeve 62 with respect to the electro-opto component.

In a way to be described more closely below, the spring 66 and the supporting structure 64 are mutually shaped to first admit introduction of the retaining sleeve 62 with the sheathed fibre 60 kept thereby in the direction of the arrow 68, before the spring 66 which may thereupon be introduced in the direction of the arrow 70 and according to the dashed lines 72 and 74 sidewardly in the supporting structure.

The spring 66 is made in one piece of two spring legs 76 and 78 bent into a V-shape and arranged in parallel with and joined together at the end of the leg of the respective V by means of ties 80 and 82, respectively. On location in the supporting structure 64 the spring 66 straddles the retaining sleeve 62 with the V-shaped spring legs 76 and 78 on each side thereof and commonly acting between an abutment 84 on the sleeve 62 extending around the circumference of the sleeve 62, and an abutment 86 in the support structure.

The support structure 64 is essentially cage shaped and comprises, while referring to Figs. 7-9, a passage for the retaining sleeve 62 extending in the direction of the arrow 68. This passage includes in turn, in the direction of the arrow 68, an opening 88 located in an end wall 90, an opening 92 located in an intermediate wall 94, and an end opening 96, that is located at the other end of the supporting structure 64 with respect to the end wall 90. The end wall 90 and the intermediate wall 94 delimit each an upper edge, as seen in Figs. 7 and 9, together with sidewalls 98 and 100 extending therebetween, a rectangular side opening towards said passage for introducing the spring 66 in the direction of the arrow 70. As appears from Fig. 9 the abutment 86 is located in this side opening on the side of the end wall 90 facing the side opening.

When located in the supporting structure 64, the spring 66 is kept in place by the edge of the V of the respective V-shaped spring parts 76 and 78 snapping under the free end 102 and 104, respectively, of each a tongue 106 and 108, respectively, formed in each one of the side walls 98 and 100, respectively. The legs of the spring parts 76 and 78 facing the wall 94 then abut the abutment 84 of the sleeve 62 on each side of the sleeve, and the tie 82 of the spring 66 abuts the abutment 86. The abutment 84, which accordingly is located between the walls 90 and 94, forms one side of a radial extension from the sleeve, the other side 110 of which by engagement with the intermediate wall 94 delimiting movement of the sleeve 62 in the direction of the arrow 68. Movement of the sleeve 62 in the other direction is limited by the engagement of the spring 66 therewith. In Fig. 10 the locations for the abutment 86 and the intermediate wall 94 with respect to the sleeve 94 are indicated when the sleeve is in its mounted position in the supporting structure 64.

Further referring to Fig. 10, the sleeve is assembled, in the shown embodiment, of two mutually concentric parts, viz. a fibre keeping part 112 and a fibre guiding in part 114. The parts 112 and 114 are both essentially bottle shaped with a neck portion 116 and 118, respectively, and a mantle portion 120 and 122, respectively, with open bottom, the mantle portion 122 carrying the radial extension 84/110. The mantle portion 120 furthermore is surrounded by a collar 124 extending outwardly from its bottom edge and being essentially of the same length as the mantle portion 120 and extending parallel with this so that they delimit a gap 126 between them, the width of which is somewhat greater than the thickness of the mantle portion 122 of the part 114. The parts 112 and 114 are interconnected with the open end portion of the mantle portion 122 extending into the gap 126.

The neck portion 116 of the part 112 serves for clampingly keeping in place the sheathed fibre 60, not shown in Fig. 10, that extends up to the mouth 128 of the neck portion 118. The mouth 128 has a width corresponding to the thickness of the optofibre without sheath.

At mounting the sleeve 62 with the sheathed optofibre 60 sitting fixedly therein, first pulling of a suitable length of the sheathed optofibre through the neck portion 116 and clamping of it in the neck portion 116 by means of a suitable clamping tool is performed. Thereupon the part of the optofibre extending out of the neck portion 116 is cut to a length that is greater than the distance between the outer ends of the neck portions 116 and 118 when the sleeve 62 is ready-assembled. Thereupon the end of the optofibre is uncovered by removing a suitable length of its mantle, glue is applied on a portion of the end of the mantle portion 122 turned away from its neck portion 118, and this end is introduced into the gap 126 to the bottom thereof. This is done while simultaneously securing that the uncovered fibre end is guided into the mouth 128 so that it will at last protrude therefrom. The end thus protruding is then cut along the end surface of the neck portion 118.

A conceivable and advantageous alternative to the embodiment of the sleeve 62 shown in Fig. 10 and described above, is that the part 114 is replaced by a layer directly sprayed onto the part 112 and the sheathed optofibre clamped therein and having the same contours as the part 122 when required. The part 112 is then suitably modified so that the collar 124 disappears.

The parts 62-66 are dimensioned and mutually shaped in a way that in their ready-assembled state the support structure 64 surrounds the sleeve 62 essentially over a portion thereof that extends from the rear end of the sleeve 62 up to the transition between the mantle portion 122 and the neck portion 118.

The parts 62-66 are enclosed in an outer housing with a pipe socket 130 united therewith into one piece, via which the sheathed optofibre 60 is guided into the sleeve 62. The housing is shown in Fig. 7 as divided into an upper housing half 132 and a lower housing half 134, which in Fig. 6 are shown in a state mounted by means of screw connections 136 and 138. In Figs. 1 and 2 the same view of the connecting device 8 is shown as in Fig. 6. At 140 and 142 ears extending from each of the housing halves 132 and 134, respectively, are shown containing screw holes. Referring also to Figs. 1 and 2 the upper part 18 and the lower part 16 of the housing 2 have correspondingly extending ears 144 and 146, respectively, provided with screw holes. The ears 140 and 144 provided with holes with a screw passing therethrough, on the one hand, and the ears 142 and 146 provided with holes with a screw passing therethrough, on the other hand, each form a screw joint for joining, according to the dashed lines 148 and 150, respectively, the contact device 8 with the housing 2, with the housing 130/132 guided into the guiding-in part 9. In this position the mouth 128 of the sleeve 62 in the housing 6 is in a correct position with respect to the electro-optic component enclosed therein. The receiving tube 7 then extends into the support structure 64 approximately up to its intermediate wall 94, tolerances of the retaining sleeve 62 in its length direction with respect to the electro-optic component being taken up by the spring 66.

## Claims

1. An electro-optic circuit with an arrangement that comprises
optic sender and receiver components for transforming an electric output signal to an outgoing optic signal and for transforming a received optic signal to an electric input signal, respectively,
connection means (6,7) for receiving one end of an opto conductor (60) on which the outgoing and received optic signals are transmitted,
a sender for the electric output signal, and
a receiver for the electric input signal,
wherein the electro-optic circuit forms a module comprising an electromagnetically shielded housing (2) having a metallic lower part (16) and a metallic upper part (18) together enclosing said optical sender and receiver components and said connection means (6, 7), a printed circuit card (10), having an upper side, a lower side is located between said lower housing part (16) and said upper housing part (18), **characterized in that**
the printed circuit card has an electrically conducting shielding (50) between its two sides, wherein the card (10) carries the sender on one side and the receiver on the other side such that the sender and the receiver are located shielded from each other by means of the shielding (50), and that
the housing (2) contains contact means (20), arranged to provide connection between the upper and lower housing parts (16,18) and between the housing (2) and grounding parts of the printed circuit card (10) and an outer mother card (4) on which the module is attachable, said contact means comprising a number of longitudinal spring means (22) arranged along the insides of the upper and lower housing parts, each spring means being shaped in one piece and being adapted to provide a number of contact points (48) with the printed circuit card (10), a number of contact points (32) with the lower housing part (16,42), a number of contact points (34) with the upper housing part (18,46), and a number of contact points (40) with the outer mother card (4),
such that one Faraday's cage is formed by the metallic lower housing part (16) and the shielding (50), and another Faraday's cage is formed by the shielding (50) and the metallic upper housing part (18).

2. An arrangement according to claim 1, **characterized in that** each spring means comprises
a first web portion (22) that extends along the longitudinal direction of the spring means between the inside of a round about extending side wall (42) of the lower part (16) and a side edge (44), facing this side wall, of the printed circuit card arrangement (10),
a second web portion (24) that extends between the outside of said side wall (42) of the lower part (16) and the inside of a round about extending side wall (42) of the upper portion (18),
first contact tongues (32) bent away from an upper edge of the second web portion (24) for contact with the outside of the side wall (42) of the lower part (16),
second contact tongues (34) bent away from an upper edge of the first web portion (22) for contact with the inside of the side wall (46) of the upper part (18),
third contact tongues (36), extending between and abutting the grounding portions of the printed circuit card (10) and the outer mother card (4).

3. An arrangement device according to claim 2,
**characterized in that** the first (22) and second (24) web portions are interconnected by arcuate connection pieces (26) extending over the side wall (42) of the lower part (16), and that a first (32) and a second (34) contact tongue are pairwise arranged in spaces between the connection pieces (26).

4. An arrangement according to claim 2 or 3,
**characterized in that** each of the third contact tongues (36) has an inner leg (38) bent away from the first web portion (22) in between the printed circuit card (10) and the outer mother card (4), and the upper side of which is shaped for contact with the grounding portion of the printed circuit card (10), and an outer leg (40), that is bent away from the inner leg under an acute angle in direction towards the outer mother card (4) for making contact with the grounding portion thereof.

## Revendications

1. Circuit électro-optique muni d'un agencement qui comprend
des composants émetteur et récepteur optiques destinés à transformer un signal de sortie électrique en un signal optique sortant et destinés à transformer un signal optique reçu en un signal électrique d'entrée, respectivement,
des moyens de connexion (6, 7) destinés à recevoir une extrémité d'un conducteur optique (60) sur lequel les signaux optiques sortant et reçu sont transmis,
un émetteur pour le signal de sortie électrique, et
un récepteur pour le signal électrique d'entrée,
dans lequel le circuit électro-optique forme un module comprenant un boîtier à blindage électromagnétique (2) comportant une partie inférieure métallique (16) et une partie supérieure métallique (18) enfermant ensemble lesdits composants émetteur et récepteur optiques et lesdits moyens de connexion (6, 7), une carte à circuit imprimé (10) comportant une face supérieure, une face inférieure, est située entre ladite partie de boîtier inférieure (16) et ladite partie de boîtier supérieure (18), **caractérisé en ce que**
la carte de circuit imprimé comporte un blindage électriquement conducteur (50) entre ses deux faces, la carte (10) portant l'émetteur sur une face et le récepteur sur l'autre face de sorte que l'émetteur et le récepteur se trouvent blindés l'un vis-à-vis de l'autre au moyen du blindage (50), et **en ce que**
le boîtier (2) contient des moyens de contact (20), agencés pour procurer une connexion entre les parties de boîtier supérieure et inférieure (16, 18) et entre le boîtier (2) et des parties de mise à la masse de la carte de circuit imprimé (10) et une carte mère extérieure (4) sur laquelle le module peut être fixé, lesdits moyens de contact comprenant un certain nombre de moyens de ressorts longitudinaux (22) disposés le long des intérieurs des parties de boîtier supérieure et inférieure, chaque moyen de ressort étant formé en une seule pièce et étant conçu pour procurer un certain nombre de points de contact (48) avec la carte de circuit imprimé (10), un certain nombre de points de contact (32) avec la partie de boîtier inférieure (16, 42), un certain nombre de points de contact (34) avec la partie de boîtier supérieure (18, 46) et un certain nombre de points de contact (40) avec la carte mère extérieure (4),
de sorte qu'une cage de Faraday est formée par la partie de boîtier inférieure métallique (16) et le blindage (50), et une autre cage de Faraday est formée par le blindage (50) et la partie de boîtier supérieure métallique (18).

2. Agencement selon la revendication 1, **caractérisé en ce que** chaque moyen de ressort comprend
une première partie de bande (22) qui s'étend suivant la direction longitudinale du moyen de ressort entre l'intérieur d'une paroi latérale d'entourage (42) de la partie inférieure (16) et un bord latéral (44), face à cette paroi latérale, de l'agencement de carte de circuit imprimé (10),
une seconde partie de bande (24) qui s'étend entre l'extérieur de ladite paroi latérale (42) de la partie inférieure (16) et l'intérieur d'une paroi latérale d'entourage (42) de la partie supérieure (18),
des premières languettes de contact (32) recourbées à partir d'un bord supérieur de la seconde partie de bande (24) en vue d'un contact avec l'extérieur de la paroi latérale (42) de la partie inférieure (16),
des secondes languettes de contact (34) recourbées depuis un bord supérieur de la première partie de bande (22) en vue d'un contact avec l'intérieur de la paroi latérale (46) de la partie supérieure (18),
des troisièmes languettes de contact (36) s'étendant entre les parties de mise à la masse de la carte de circuit imprimé (10) et de la carte mère extérieure (4), et butant contre celles-ci.

3. Dispositif d'agencement selon la revendication 2, **caractérisé en ce que** la première (22) et la seconde (24) parties de bande sont interconnectées par des pièces de liaison incurvées (26) s'étendant sur la paroi latérale (42) de la partie inférieure (16), et **en ce qu'**une première (32) et une seconde (34) languettes de contact sont disposées par paire dans des espaces entre les pièces, de liaison (26).

4. Agencement selon la revendication 2 ou 3, **caractérisé en ce que** chacune des troisièmes languettes de contact (36) comporte une branche intérieure (38) recourbée depuis la première partie de bande (22) entre la carte de circuit imprimé (10) et la carte mère extérieure (4), et dont le bord supérieur est formé de manière à entrer en contact avec la partie de mise à la masse de la carte de circuit imprimé (10), et une branche extérieure (40), qui est recourbée depuis la branche intérieure sous un angle aigu dans une direction allant vers la carte mère extérieure (4), afin d'établir un contact avec la partie de mise à la masse de celle-ci.

## Patentansprüche

1. Elektro-optische Schaltung mit einer Anordnung, die Folgendes umfasst:
optische Sender- und Empfängerkomponenten zum Umwandeln eines elektrischen Ausgangssignals in ein abgehendes optisches Signal bzw. zum Umwandeln eines empfangenen optischen Signals in ein elektrisches Ausgangssignal;
ein Verbindungsmittel (6, 7) zum Aufnehmen eines Endes eines optischen Leiters (60), über den die abgehenden und empfangenen optischen Signale übertragen werden;
einen Sender für das elektrische Ausgangssignal, und
einen Empfänger für das elektrische Eingangssignal;
wobei die elektro-optische Schaltung ein Modul bildet, das ein elektromagnetisch abgeschirmtes Gehäuse (2) umfasst, das einen metallischen unteren Teil (16) und einen metallischen oberen Teil (18) aufweist, die gemeinsam die optischen Sender- und Empfängerkomponenten und das Verbindungsmittel (6, 7) umschließen;
eine gedruckte Leiterplatte (10) mit einer Oberseite und einer Unterseite, die zwischen dem unteren Gehäuseteil (16) und dem oberen Gehäuseteil (18) angeordnet ist; **dadurch gekennzeichnet, dass**
die gedruckte Leiterplatte eine elektrisch leitfähige Abschirmung (50) zwischen ihren beiden Seiten aufweist, wobei die Platte (10) den Sender auf einer Seite trägt und den Empfänger auf der anderen Seite trägt, dergestalt, dass der Sender und der Empfänger so angeordnet sind, dass sie mittels der Abschirmung (50) voneinander abgeschirmt sind, und dass
das Gehäuse (2) ein Kontaktmittel (20) enthält, das so angeordnet ist, dass es eine Verbindung zwischen dem oberen und dem unteren Gehäuseteil (16, 18) und zwischen dem Gehäuse (2) und Erdungsteilen der gedruckten Leiterplatte (10) und einer äußeren Hauptplatine (4), auf der das Modul angebracht werden kann, herstellt, wobei das Kontaktmittel eine Anzahl in Längsrichtung ausgerichteter Federmittel (22) umfasst, die entlang den Innenseiten des oberen und des unteren Gehäuseteils angeordnet sind, wobei jedes Federmittel einstückig ausgebildet ist und dafür konfiguriert ist, eine Anzahl von Kontaktpunkten (48) mit der gedruckten Leiterplatte (10), eine Anzahl von Kontaktpunkten (32) mit dem unteren Gehäuseteil (16, 42), eine Anzahl von Kontaktpunkten (34) mit dem oberen Gehäuseteil (18, 46) und eine Anzahl von Kontaktpunkten (40) mit der äußeren Hauptplatine (4) bereitzustellen,
dergestalt, dass durch das metallische untere Gehäuseteil (16) und die Abschirmung (50) ein Faradayscher Käfig gebildet wird und durch die Abschirmung (50) und das metallische obere Gehäuseteil (18) ein weiterer Faradayscher Käfig gebildet wird.

2. Anordnung nach Anspruch 1, **dadurch gekennzeichnet, dass** jedes Federmittel Folgendes umfasst:
einen ersten Stegabschnitt (22), der sich in der Längsrichtung des Federmittels zwischen der Innenseite einer sich rundherum erstreckenden Seitenwand (42) des unteren Teils (16) und einem Seitenrand (44), der dieser Wand zugewandt ist, der Leiterplattenanordnung (10) erstreckt,
einen zweiten Stegabschnitt (24), der sich zwischen der Außenseite der Seitenwand (42) des unteren Teils (16) und der Innenseite einer sich rundherum erstreckenden Seitenwand (42) des oberen Teils (18) erstreckt,
erste Kontaktzungen (32), die von einem oberen Rand des zweiten Stegabschnitts (24) fort gebogen sind, um die Außenseite der Seitenwand (42) des unteren Teils (16) zu berühren,
zweite Kontaktzungen (34), die von einem oberen Rand des ersten Stegabschnitts (22) fort gebogen sind, um die Innenseite der Seitenwand (46) des oberen Teils (18) zu berühren,
dritte Kontaktzungen (36), die sich zwischen den Erdungsabschnitten der gedruckten Leiterplatte (10) und der äußeren Hauptplatine (4) erstrecken und daran anstoßen.

3. Anordnungsvorrichtung nach Anspruch 2, **dadurch gekennzeichnet, dass** die ersten (22) und die zweiten (24) Stegabschnitte durch bogenförmige Verbindungsstücke (26), die sich über die Seitenwand (42) des unteren Teils (16) erstrecken, miteinander verbunden sind und dass eine erste (32) und eine zweite (34) Kontaktzunge paarweise in Räumen zwischen den Verbindungsstücken (26) angeordnet sind.

4. Anordnung nach Anspruch 2 oder 3, **dadurch gekennzeichnet, dass** jede der dritten Kontaktzungen (36) einen inneren Schenkel (38) aufweist, der zwischen der gedruckten Leiterplatte (10) und der äußeren Hauptplatine (4) von dem ersten Stegabschnitt (22) fort gebogen ist und dessen Oberseite so geformt ist, dass ein Kontakt zu dem Erdungsabschnitt der gedruckten Leiterplatte (10) hergestellt wird; und einen äußeren Schenkel (40) aufweist, der von dem inneren Schenkel in einem spitzen Winkel in einer Richtung zu der äußeren Hauptplatine (4) hin fort gebogen ist, um zu deren Erdungsabschnitt einen Kontakt herzustellen.
